(19) Europäisches Patentamt

European Patent Office

Office européen des brevets

(11) **EP 4 696 417 A1**

(12) **EUROPEAN PATENT APPLICATION**

(43) Date of publication:
**18.02.2026 Bulletin 2026/08**

(21) Application number: **24194240.8**

(22) Date of filing: **13.08.2024**

(51) International Patent Classification (IPC):
**B04B 5/00** *(2006.01)*   **B04B 9/06** *(2006.01)*
**B04B 9/10** *(2006.01)*   **B04B 11/02** *(2006.01)*
**B04B 15/00** *(2006.01)*

(52) Cooperative Patent Classification (CPC):
**B04B 5/005; B04B 9/06; B04B 9/10; B04B 11/02; B04B 15/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **MANN+HUMMEL Ventures Pte. Ltd. Singapore 139234 (SG)**

(72) Inventors:
• **PRABHAKAR, Vikas Jilakarapalli**
  **71636 Ludwigsburg (DE)**
• **FELL, Anthony William**
  **71636 Ludwigsburg (DE)**
• **BEYLICH, Markus**
  **71636 Ludwigsburg (DE)**

(74) Representative: **Mann + Hummel Intellectual Property**
**Mann + Hummel**
**International GmbH & Co. KG**
**Schwieberdinger Straße 126**
**71636 Ludwigsburg (DE)**

(54) **CENTRIFUGAL SEPARATOR ARRANGEMENT, SYSTEM AND METHOD FOR ENERGY HARVESTING IN A CENTRIFUGAL SEPARATOR ARRANGEMENT**

(57)    The present invention relates to a centrifugal separator arrangement, the arrangement comprising: an energy converter positioned in proximity to a rotor of the centrifugal separator arrangement and configured to collect and convert the non-electrical energy collected from the centrifugal separator into electrical energy; a sensor configured to obtain a parameter associated with the operation of the centrifugal separator, wherein the sensor comprises a processor configured to produce corresponding data; wherein the sensor is in electrical connection with the energy converter to be powered by the electrical energy produced by the energy converter. The present invention also relates to a method and a system for energy harvesting in the centrifugal separator arrangement.

FIG. 1

EP 4 696 417 A1

**Description**

**Technical Field**

An aspect of the disclosure relates to a centrifugal separator arrangement. Further aspects of the disclosure relate to a method and a system for energy harvesting in the centrifugal separator arrangement.

**Background Art**

Centrifugal separators are devices that work on the principle of using centrifugal forces to separate various components of or from a fluid. This is achieved by spinning the fluid at high speed in a centrifugal separator, thereby separating fluids of different densities or liquids from solids. In a rotor of the centrifugal separator, denser substances and particles (e.g., particulate contaminants) move outward in the radial direction and compact along a wall of the rotor to form a dense cake. At the same time, medium that is less dense (e.g., clean fluid) is displaced and moved to the center of the rotor.

While the centrifugal separator itself may not require the use of electricity, equipment (such as sensors) used for the maintenance and operation of such centrifugal separators often require an electrical source. This is cumbersome, since power points have to be connected and/or batteries have to be (re)placed and their lifetime has to be monitored. Thus, there is a need to provide for an improved centrifugal separator arrangement; and a method and a system for energy harvesting in the centrifugal separator arrangement.

In a more particular case, maintenance to remove the dense cake from the wall may involve removing a cover of the rotor and then removing the rotor from its bearing (e.g., a spindle).

On one hand, such a maintenance operation is frequently not necessary, because the accumulation of the dense cake on the wall of the rotor may not yet have reached a stage that warrants/requires removal. However, using conventional maintenance methods, the stage of the dense cake on the wall of the rotor is typically unknown to the operator until after the centrifugal separator is disassembled, which may lead to unnecessary disassembly of the centrifugal separators. This unnecessary disassembly may result in unnecessary downtime of the centrifugal separator, a waste of manpower and a decrease in efficiency. On the other hand, if the rotor was allowed to continue in operation for too long, the dense cake could fall into the clean fluid, thereby contaminating the clean fluid, which may result in an inefficient separation. Moreover, the dense cake may collapse and restrict the oil flow, affecting the rotor performance.

Thus, there is also a need to provide for an improved maintenance method.

**Summary**

An aspect of the disclosure relates to a centrifugal separator arrangement. The centrifugal separator arrangement may include a centrifugal separator. The centrifugal separator may include a stationary casing defining an enclosure. The centrifugal separator may include the rotor including a wall defining an inner volume, wherein the rotor may be rotatably mounted in the enclosure to rotate about a rotation axis, optionally about a longitudinal rotation axis. The centrifugal separator may include a feed passage for supplying a contaminated fluid including particulate contaminant and allowing the contaminated fluid to flow to the inner volume of the rotor. The centrifugal separator may include an egress opening for releasing a cleaned fluid from the centrifugal separator, wherein a rotor outlet channel may be configured to allow the cleaned fluid to egress in a direction including a tangential component with respect to the rotation axis, thereby causing an angular displacement of the rotor when the contaminated fluid is applied via the feed passage at a fluid pressure above a fluid pressure threshold, thereby causing the rotor to rotate and to generate non-electrical energy during rotation. The centrifugal separator arrangement may further include an energy converter positioned in proximity to the rotor and configured to collect and convert the non-electrical energy collected from the centrifugal separator into electrical energy. The centrifugal separator arrangement may further include one or more sensors configured to obtain a parameter associated with the operation of the centrifugal separator. The one or more sensors may include a processor configured to produce corresponding data. The one or more sensors may be operably connected with the energy converter to be powered by the electrical energy produced by the energy converter.

According to various embodiments, the centrifugal separator arrangement may include that the non-electrical energy collected from the centrifugal separator is mechanical energy.

According to various embodiments, the mechanical energy may be vibrational energy.

According to various embodiments, the energy converter may include a piezoelectric transducer configured to be subjected to mechanical vibrations.

According to various embodiments, the energy converter may include an AC-DC rectifier configured to generate DC voltage.

According to various embodiments, the non-electrical energy collected from the centrifugal separator may be thermal energy.

According to various embodiments, the energy converter may include a thermoelectric generator configured to be subjected to a heat source and a heat sink.

According to various embodiments, the energy converter may include a DC-DC converter configured to adjust DC voltage generated by the energy converter.

According to various embodiments, the energy converter may include a capacitor arranged to smooth out the DC voltage to reduce ripples.

According to various embodiments, the centrifugal separator arrangement may further include an energy storage device.

According to various embodiments, the sensor may include a rotation sensor configured to measure a change in the rotation frequency of the rotor and produce corresponding rotor rotation data.

According to various embodiments, the rotor rotation data and transient control parameters for controlling an applied fluid pressure may be configured to be used for determining a load of accumulated particulate contaminant separated from the cleaned fluid caused by the particulate contaminant deposited on an inner surface of the wall. The loading of the rotor may be determined based on the rotor rotation data and the transient control parameters.

An aspect of the disclosure relates to a method for energy harvesting in the centrifugal separator arrangement as defined herein. The method may include a step of providing the centrifugal separator arrangement as described herein. The method may include a step of subjecting the energy converter to a position suitable for harvesting the non-electrical energy. The method may include a step of converting the non-electrical energy into electrical energy. The method may include a step of providing the electrical energy to the sensor.

An aspect of the disclosure relates to a system for energy harvesting in the centrifugal separator arrangement. The system may include the centrifugal separator arrangement as described herein. The energy converter may be configured to harvest non-electrical energy generated during rotation of the rotor. The energy converter may be configured to convert the non-electrical energy to electrical energy. The energy converter may be configured to power the sensor with the electrical energy.

## Brief Description of Drawings

The drawings show:

FIG. 1    A centrifugal separator arrangement in accordance with various embodiments.
FIG. 2    A thermoelectric generator in accordance with various embodiments.
FIG. 3    A method for energy harvesting in the centrifugal separator arrangement in accordance with various embodiments.
FIG. 4    A system for energy harvesting in the centrifugal separator arrangement in accordance with various embodiments.
FIG. 5    A graph showing one example of determining a loading of a rotor of a centrifugal separator arrangement in accordance with various embodiments.
FIG. 6    An illustration of a curve fitting in accordance with various embodiments.

## Detailed Description

The following detailed description refers to the accompanying drawings that show, by way of illustration, specific details and embodiments in which the disclosure may be practiced. These embodiments are described in sufficient detail to enable those skilled in the art to practice the disclosure. Other embodiments may be utilized and structural, and logical changes may be made without departing from the scope of the disclosure. The various embodiments are not necessarily mutually exclusive, as some embodiments can be combined with one or more other embodiments to form new embodiments.

Embodiments described in the context of one of a centrifugal separator arrangement, a method for energy harvesting and a system for energy harvesting in the centrifugal separator arrangement are analogously valid for the other of centrifugal separator arrangement, method for energy harvesting and system for energy harvesting in the centrifugal separator arrangement.

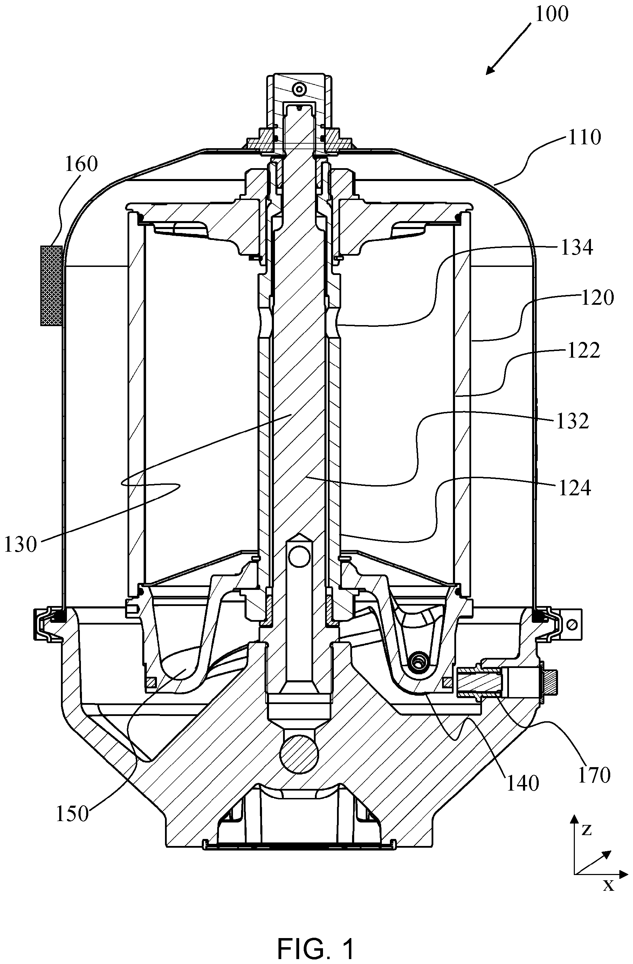

The centrifugal separator arrangement 100 in accordance with various embodiments is illustrated in FIG. 1. As shown therein, a centrifugal separator arrangement 100 may include a stationary casing 110. The stationary casing 110 may have a fixed position, for example fixed in relation to an engine (e.g., a motor, e.g., an electric motor), or a fluid cleaning system. Other parts of the centrifugal separator may be in motion in relation to the stationary casing 110. The stationary casing 110 may have a cylindrical shape. A top edge of the stationary casing 110 may be rounded, such that the top of the stationary casing 110 may resemble a bell shape. The stationary casing 110 may define an enclosure within the stationary casing 110. In other words, the stationary casing 110 may be configured to house remaining components of the centrifugal separator arrangement 100 therein.

According to various embodiments, a material of the stationary casing 110 may include, or may be, a metal or a metal alloy. For example, the material of the stationary casing 110 may include aluminum, or an aluminum alloy. In some embodiments, the material of the stationary casing 110 may be diamagnetic.

The centrifugal separator arrangement 100 may further include a rotor 120 which may be rotatably mounted (e.g., around a rotation axis) in an enclosure defined by the stationary casing 110. The rotation axis may be a longitudinal rotation axis. In other words, while the stationary casing 110 may be configured to be affixed to a structure, the rotor 120 may be configured to be in rotating motion (e.g., around the rotation axis) in relation to the stationary casing 110. The rotor 120 may be substantially enclosed within the stationary casing 110. The rotor 120 may have a cylindrical shape and may follow the contours of the stationary casing 110 at a smaller diameter of the cylinder than that of the stationary casing 110. The rotor 120 may include a wall 122 defining an inner volume. The inner volume may surround the rotation axis (e.g., in a rotationally symmetric manner). The wall 122 may therefore be positioned towards the center of the rotor, i.e. facing away from the stationary casing 110. In some embodiments, the rotor 120 may be rotatably mounted within the stationary casing 110 by being mounted on a spindle 124.

According to various embodiments, a material of the rotor 120 may include, or may be, a metal or a metal alloy. For example, the material of the rotor 120 may include aluminum, or an aluminum alloy. Advantageously, the material of the rotor 120 may be diamagnetic.

The centrifugal separator arrangement 100 may further include a feed passage 130. The feed passage 130 may be defined by an inner wall 132 of the spindle 124 and may extend in an axial direction (identified as a direction z in FIG. 1) within the rotor 120. The feed passage 130 may be configured to supply a contaminated fluid including particulate contaminants. In particular, the feed passage 130 may allow the contaminated fluid including particulate contaminants to flow through the feed passage 130 and into the inner volume of the rotor 120.

The contaminated fluid including particulate contaminants may be referred to as a fluid and, dissolved or dispersed therein, particulate contaminants. According to various embodiments, the contaminated fluid including particulate contaminants enters, or is pumped into, the feed passage 130. In other words, the contaminated fluid entering the rotor 120 may typically contain particulate contaminants. The contaminated fluid may then be caused, under application of centrifugal force, to be cleaned from the particulate contaminants. Additionally or alternatively, the particulate contaminants may be caused, under application of centrifugal force, to be removed (e.g., separated) from the contaminated fluid before the fluid exits the rotor 120. The fluid that exits the rotor 120 may be referred to as a cleaned fluid that contains relatively less contaminants than the contaminated fluid including particulate contaminants. Accordingly, the fluid including less particulate contaminants than the contaminated fluid may be referred to as a cleaned fluid. Cleaning may be carried out over one or more cycles of the fluid passing through the rotor. The fluid may include, or consist of, an inorganic fluid, e.g., it may be water. Alternatively, the fluid may be an organic fluid, an organic fluid, e.g., it may be a hydrocarbon, e.g., oil.

The contaminated fluid including particulate contaminants may enter into the feed passage 130 of the centrifugal separator under an applied fluid pressure and may be further directed into the rotor 120 via an inlet passage, e.g., a cross drilling 134. The rotor 120 may be entirely filled with the contaminated fluid including particulate contaminants and then a cleaned fluid may be allowed to exit through an egress opening 140 and into a rotor outlet channel 150 fitted in a bottom portion of the rotor 120. The cleaned fluid may exit through the egress opening 140 with a tangential component with respect to the rotation axis, e.g., such that a torque may be generated in an opposite direction of the egress opening of the cleaned fluid. Said torque may generate rotation of the rotor 120. This rotation may, in turn, generate a centrifugal force in the contaminated fluid including particulate contaminants within the rotor 120. As particulate contaminants along with the contaminated fluid enter the rotor 120, these may be subjected to the centrifugal force. Under the action of this centrifugal force, the particulate contaminants may move radially outwards to the inner wall 122 of the rotor 120, and may deposit, e.g., as contaminant layers, along the inner wall 122. The contaminant layers may compact and form a dense cake (not shown) with a continuous accumulation of these particulate contaminants under the centrifugal force. The dense cake may also be referred to as a load of the accumulated particulate contaminant that is configured to be separated from the cleaned fluid.

In order to monitor parameters associated with the operation of the centrifugal separator, the centrifugal separator arrangement 100 may further include one or more sensors 170. The one or more sensors 170 may detect one or more parameters that may affect optimal performance, efficiency, and safety of the separation process during operation of the centrifugal separator arrangement 100. The detection of the one or more parameters may include measuring the one or more parameters. The detection of the one or more parameters may be used to control such parameters associated with the operation of the centrifugal separator.

The one or more sensors 170 may include physical sensors, which may include hardware-based sensors. The one or more sensors 170 may include soft sensors, which may include software-based algorithms and models. The one or more sensors 170 may also include a combination of hard and soft sensors. The one or more sensors 170 may include one or more wireless sensors. The parameters that are associated with the operation of the centrifugal separator may include, e.g., rotation frequency of the rotor 120. The parameters that are associated with the operation of the centrifugal separator may include the frequency of the rotor 120. The parameters that are associated with the operation of the centrifugal separator may include the temperature of the contaminated fluid. The parameters that are associated with the operation of the centrifugal separator may include the flow rate of the contaminated fluid. The parameters that are associated with the operation of the centrifugal separator may include the pressure of the contaminated fluid.

Accordingly, hardware-based sensors 170 associated to monitor such parameters may include a rotation sensor. Hardware-based sensors 170 associated to monitor such parameters may include a temperature sensor. The temperature sensor may include one or more of a thermocouple, and a resistance temperature detector (RTD). Hardware-based sensors 170 associated to monitor such parameters may also include a vibration sensor. The vibration sensor may include one or more of an accelerometer and a velocity sensor. Hardware-based sensors 170 associated to monitor such parameters may also include a pressure sensor. The pressure sensor may include one or more of a piezoelectric sensor and a strain gauge sensor. Hardware-based sensors 170 associated to monitor such parameters may also include a flow sensor. The flow sensor may include one or more of a turbine flow meter and a Coriolis flow meter. Such sensors may require electricity to operate.

Soft sensors 170 may include model-based algorithms, configured to use mathematical models to estimate and predict process parameters that are difficult or expensive to measure directly. The soft sensors may also be termed virtual sensors. They may include one or more of Kalman filters and observer-based techniques, which use system models to estimate states and outputs of the separation process. Soft sensors 170 may also include machine learning models. The machine learning models may include one or more of a regression model and a neural network. Soft sensors 170 may also include one or more of data fusion techniques, such as sensor fusion algorithms.

Providing this electricity to the sensors 170 of the centrifugal separator arrangement 100, which otherwise may be operated without the use of electricity, may be cumbersome, requires maintenance (e.g., replacing the batteries) and is an effort that is proportionally high for the little electricity that sensors typically require. Accordingly, this disclosure provides for a centrifugal separator arrangement 100, wherein the non-electrical energy produced during the operation of the centrifugal separator may be converted into electrical energy, which is, in turn, provided to the one or more sensors 170. To collect and convert the non-electrical energy into electrical energy, there is provided an energy converter 160, configured to convert non-electrical energy collected from the centrifugal separator into electrical energy. While the energy converter 160 in FIG. 1 is exemplary placed on the stationary casing 110 at about 75% of the height of the stationary casing 110, the energy converter 160 may be placed at whichever location of the centrifugal separator, that is suitable for harvesting the non-electrical energy produced during the operation of the centrifugal separator.

Advantageously, by the provision of an energy converter 160, configured to convert non-electrical energy collected from the centrifugal separator into electrical energy, problems associated with conventionally providing this electricity to the sensors of the centrifugal separator arrangement 100 are avoided. Moreover, non-electrical energy can be harvested and is not lost, which is more environmentally friendly.

The non-electrical energy produced by the operation of the centrifugal separator may include, e.g., mechanical energy. For example, the mechanical energy may be due to vibrations during operation. These vibrations may be caused by little imbalances and frequently occur during operation. The energy may then also be called vibrational energy. Vibrational energy may be harvested through various methods and materials, each with its own mechanisms and applications. Examples of harvesting vibrational energy include, but are not limited to, piezoelectric energy harvesting, electromagnetic energy harvesting, electrostatic energy harvesting, triboelectric energy harvesting, and magnetostrictive energy harvesting. An appropriate harvesting method may be selected based on the vibration characteristics of the centrifugal separator. The vibration characteristics may include frequency and amplitude of the vibration during operation of the centrifugal separator.

In one embodiment, the vibrational energy may be harvested through the use of a piezoelectric transducer 180. The piezoelectric transducer 180 may include a piezoelectric material. The piezoelectric material may include one or more of quartz, a piezoelectric ceramic material, and polyvinylidene difluoride (PVDF). An example for the piezoelectric ceramic material may include lead zirconate titanate ($Pb[Zr_{(x)}Ti_{(1-x)}]O_3$) (PZT). The piezoelectric transducer 180 may be positioned (e.g., secured) in a location where it can experience mechanical vibrations. When the piezoelectric material is deformed by the vibrations, it may generate an electric charge. This charge can be collected and stored in a capacitor or storage device. Additionally or alternatively, the charge can be used to power the one or more sensors 170.

The electric charge or electricity produced by the piezoelectric transducer 180 may be an AC voltage or current, because the stress and strain applied to the material may vary with time. This may cause the output voltage or current to alternate. Hence, in some embodiments, the centrifugal separator arrangement 100 may further include an AC-DC rectifier 182. This AC-DC rectifier 182 may convert this alternating voltage into a unidirectional DC voltage. Advantageously, generation of DC voltage may facilitate the operation of electronic circuits within the one or more sensors 170, as well as storage devices, such as batteries and capacitors.

The non-electrical energy produced by the operation of the centrifugal separator may include thermal energy. In one embodiment, the thermal energy may be due to thermodynamic changes during the operation of the centrifugal separator. In these embodiments, the thermal energy may be harvested by using, e.g., a thermoelectric generator (TEG).

This may involve converting heat (thermal energy) into electrical energy using the Seebeck effect. The Seebeck effect exploits a temperature difference across the centrifugal separator and the ambient air for generating a voltage. Briefly, the effect is based on electric current generation by joining two different conductive materials together to form a loop, wherein their junctions are maintained at different temperatures. Components of the thermoelectric generator using the Seebeck effect may include thermoelectric materials. The thermoelectric materials may include materials with high Seebeck coefficients. The thermoelectric materials may also include materials having a low thermal conductivity. They also include materials having a high electrical conductivity. The thermoelectric generator may thus include materials such as bismuth telluride ($Bi_2Te_3$), lead telluride (PbTe), and silicon-germanium (SiGe) alloys. Moreover, P-N junctions may be arranged by positioning many p-type and n-type semiconductor elements in pairs. These pairs may be connected electrically in series and thermally in parallel. The temperature gradient required for the harvesting of thermal energy may involve a heat source and a heat sink. The heat source may include waste heat generated from the operation of the centrifugal separator. The heat sink may include ambient air or a cooling system. During harvesting of the thermal energy, a temperature difference may be established between the hot side and the cold side of the thermoelectric materials, and the temperature difference may cause charge carriers in the materials (electrons in n-type and holes in p-type) to diffuse from the hot side to the cold side. This movement of charge carriers may generate a voltage across the material. The voltage generated by each thermocouple pair may be small, but when many pairs are connected in series, the voltages add up, resulting in a usable output voltage.

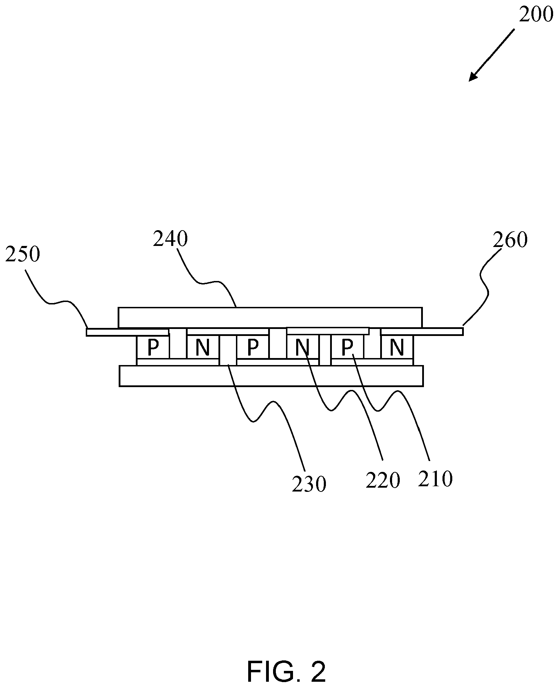

FIG. 2 is a schematic drawing of a thermoelectric generator 200 as an example of one embodiment of the disclosure. It is shown therein, that p-type semiconductor elements 210 and n-type semiconductor elements 220 are arranged in pairs, leaving gaps for conductor tabs 230. The p-type and n-type semiconductor elements 210, 220 are sandwiched between two substrates, one of which is shown as substrate 240. One of the substrates 240 is positioned at the heat side of the thermoelectric generator 200 (e.g., heat source), while the other side of the thermoelectric generator 200 is positioned at the cold side of the thermoelectric generator 200 (e.g., heat sink). The substrates 240 are exemplified as a ceramic material, but could alternatively include one or more of a polymeric material, a metallic material, and glass. Where the substrate 240 is a ceramic substrate, the material may be selected from the group consisting of aluminium oxide, aluminium nitride, silicon carbide, and a combination thereof. The voltage generated by the thermoelectric generator 200 is collected at the + and - poles 250/260.

Unlike the electrical energy converted by the piezoelectric transducer 180, the electrical energy that is obtained from the TEG may be DC voltage. Accordingly, when using a TEG as energy converter 160, an AC-DC rectifier may not be needed. However, in some embodiments, a DC-DC converter may be used to adjust the voltage level to match the requirements of the one or more sensors 170.

The non-electrical energy produced by the operation of the centrifugal separator may also include light energy. The light energy may be harvested through one or more photovoltaic cells. The photovoltaic cells may include one or more of a silicon-based cell, a dye-sensitized solar cell, an organic photovoltaic cell, and a perovskite solar cell. Additionally, light energy may be harvested through a concentrated solar power system by using focused sunlight to generate thermal energy, which may be then converted into electricity as detailed above.

The non-electrical energy produced by the operation of the centrifugal separator may also include sound energy. The sound energy may include the same or similar characteristics of mechanical energy. The sound energy may thus be harvested similarly to the vibrational energy as detailed above. Accordingly, the harvesting of sound energy may include using one or more of piezoelectric energy harvesting, electromagnetic energy harvesting, electrostatic energy harvesting, triboelectric energy harvesting, and magnetostrictive energy harvesting.

The placement of the energy converter 160 may depend on the nature of the energy converter 160 and may be generally in proximity to the rotor 120. For example, where the energy converter 160 converts mechanical energy into electrical energy, it may be advantageous to place the energy converter 160 to be in contact with one or more of the rotor 120 and the stationary casing 110. In some embodiments, the energy converter 160 for converting mechanical energy into electrical energy may be placed at a position where the vibrations generated by the rotor 120 are maximized.

Where the energy converter 160 converts thermal energy into electrical energy, it may be advantageous to place the energy converter 160 to be in contact with a heat source and one of ambient air or a cooling system. It should be noted that the placement of the energy converter 160 in FIG. 1 in this regard is one example, and it is understood that the placement of the energy converter 160 converting thermal energy into electrical energy may require contact with two surfaces, as further described below. In some embodiments, the energy converter 160 for converting thermal energy into electrical energy may be placed at a position where the temperature gradient between the heat source and the heat sink is maximized. In other words, the energy converter 160 for converting thermal energy into electrical energy may be placed to be in contact with a hot surface, wherein the heat is generated by the operation of the centrifugal separator, and a cold surface. The terms "hot" and "cold", in this context, are meant to be defined in relation to each other, wherein "hot surface" refers to a surface having a higher temperature than a surface referred to as "cold surface". An example of the hot surface may be the stationary casing 110 and an example of the cold surface may be a radiator. One example of a radiator is a metal heatsink.

In some embodiments, the DC voltage that is generated by the conversion from the non-electrical energy as described above may further be subjected to a capacitor 162. The capacitor 162 may have the function of smoothing out the DC voltage to reduce ripples in the voltage.

In some embodiments, the energy converter 160 may further include a voltage rectifier 164. The voltage rectifier 164 may have the function to ensure that the DC voltage that is generated by the conversion from the non-electrical energy remains stable and within the desired range.

In some embodiments, the centrifugal separator arrangement 100 may additionally include an energy storage device 166. This energy storage device 166 may be a rechargeable battery or a supercapacitor. The energy storage device 166 may have the function of storing the DC voltage that is generated by the conversion from the non-electrical energy for later use. The energy storage device 166 may be in electrical connection with both the energy converter 160 and the one or more sensors 170. For example, the energy storage device 166 may be connected via a cable with both the energy converter 160 and the one or more sensors 170.

In a particular embodiment, the one or more sensors 170 may include a radio frequency (RF) attenuation monitoring system. The RF attenuation monitoring system may use RF signals that are absorbed or scattered by the materials within the centrifugal separator to provide real-time data. The real-time data may include data giving an indication on the contents and operational state of the centrifugal separator. In further detail, and in some embodiments, the RF attenuation monitoring system may use a transmitter to generate and emit RF signals at specific frequencies. Subsequently, an RF receiver may detect the attenuated RF signals after they have passed through the separator. The RF attenuation monitoring system may then use antennas for transmitting and receiving RF signals. Thus, the antennas may be placed externally and/or internally, depending on the design of the centrifugal separator and the monitoring needs. The RF attenuation monitoring system may also include a processor (further defined below), which may include a signal processing unit. The signal processing unit may analyse the received RF signals to extract corresponding data about the contents and state of the centrifugal separator. In one embodiment, the RF attenuation monitoring system may also include a control and display system. The control and display system may allow operators to monitor real-time data and receive alerts about the centrifugal separator's operation.

In a further particular embodiment, the sensor 170 may be a rotation sensor 172 that may be configured to obtain a change in the rotation frequency of the rotor and produce corresponding rotor rotation data. According to various embodiments, the sensor 170 may be attached to the centrifugal separator. The attachment of the sensor 170 to the centrifugal separator may be a non-removable attachment. The one or more sensors 170 may be in electrical connection with both the energy storage device 166 (if present) and the energy converter 160. For example, the one or more sensors 170 may be connected via a cable with the energy storage device 166 (if present) and the energy converter 160.

The one or more sensors 170 may also include a processor, also termed as a server. The processor may be configured to produce data corresponding to the parameter that is associated with the operation of the centrifugal separator. The corresponding data may thus represent a value of the parameter and/or a difference of the parameter over time, that is associated with the operation of the centrifugal separator. In some embodiments, the parameter may include a transient control parameter further described below.

Data corresponding to the parameter that is associated with the operation of the centrifugal separator may include one or more of a specific temperature, a specific pressure, a specific rotation frequency, and a flow rate of the contaminated fluid. Data corresponding to the parameter that is associated with the operation of the centrifugal separator may also include a change overtime in one or more of the specific temperature, the specific pressure, the specific rotation frequency, and the flow rate of the contaminated fluid.

As used herein, the term "server" or "processor" may include a single stand-alone computer, a single dedicated server, multiple dedicated servers, and/or a virtual server running on a larger network of servers and/or cloud-based service. The processor may include integrated circuit (IC) chips such as application specific integrated circuit (ASIC) chips.

In embodiments in which the sensor 170 is a rotation sensor 172, the rotation sensor 172 may be selected from a hall effect sensor, a magneto-resistive sensor, a giant magneto-resistive sensor, or a combination thereof. The rotation sensor 172 may be a hall effect sensor. The hall effect sensor may work together with a magnet, which may be attached to the rotor 120.

Advantageously, this rotation sensor 172 and corresponding rotor rotation data may be used in a method of determining a loading of the rotor 120 of the centrifugal separator arrangement 100.

In order to determine a loading of the rotor 120, e.g., the weight of the total content of the rotor 120, which may provide an indication of a load of accumulated particulate contaminant, e.g., the stage of the dense cake, the method as provided herein takes advantage of the mathematical correlation between rotor rotation data and an applied fluid pressure, wherein the applied fluid pressure may be controlled by transient control parameters. In other words, since the loading of the rotor 120 correlates with a moment of inertia of the rotor 120, an angular acceleration of the rotor 120 would change depending on the loading, thereby providing for a determination of the stage of the dense cake without the necessity of disassembly of the centrifugal separator arrangement 100. For the measurement of the rotor rotation data, the centrifugal separator arrangement 100 may include the rotation sensor 172 configured to measure a rotation of the rotor 120 and produce corresponding rotor rotation data. For the measurement of the transient control parameters, the centrifugal separator arrangement 100 may include a detector, including, e.g., a temperature sensor and/or a pressure sensor.

Accordingly, in some embodiments, there is also provided a centrifugal separator arrangement 110, wherein the rotor rotation data and transient control parameters for controlling an applied fluid pressure are configured to be used for determining a load of accumulated particulate contaminant separated from the cleaned fluid caused by the particulate contaminant deposited on an inner surface of the wall 122. The loading of the rotor 120 may be determined based on the rotor rotation data and the transient control parameters. The use (e.g., method) of the rotor rotation data and transient control parameters for controlling an applied fluid pressure may include providing transient control parameters for controlling an applied fluid pressure. The method may include a step of producing a change in a rotation frequency of the rotor by modifying the fluid pressure applied to the feed passage according to the transient control parameters. The method may include a step of receiving, from the rotation sensor, rotor rotation data corresponding to the change in the rotation frequency of the rotor. The method may include a step of determining a load of accumulated particulate contaminant separated from the cleaned fluid caused by the particulate contaminant deposited on an inner surface of the wall. The loading of the rotor 120 may be determined based on the rotor rotation data and the transient control parameters.

The method may address the shortcomings detailed above in relation with the unnecessary disassembly of the centrifugal separator arrangement and/or an inefficiency of separating the accumulated particulate contaminant from the cleaned fluid by providing a determination of the loading of the accumulated particulate contaminant in the rotor without the need of disassembling the centrifugal separator arrangement. Since there is no necessity for the disassembly of the centrifugal separator arrangement in order to determine the loading of the accumulated particulate contaminant in the rotor, resources such as time and manpower can be saved, thereby improving the operation efficiency of the centrifugal separator arrangement. Moreover, the method is not selective to the type of the accumulated particulate contaminant, since it only requires a difference in mass of the loading of the rotor. Hence, the loading of all types of accumulated particulate contaminants may be determined by using this method.

The method exploits the physical property that when a body is rotating, or is free to rotate around an axis, a torque must be applied to change its angular momentum. The amount of torque needed to cause any given angular acceleration (the rate of change in angular velocity) is proportional to the moment of inertia of the body. As the load of accumulated particulate contaminant (i.e., the dense cake) builds up inside the rotor, the loading of the rotor will increase and the moment of inertia will change. Hence the torque needed to cause an angular acceleration is expected to change as well.

In further detail, theoretically, as the loading (e.g., the load of accumulated particulate contaminant) increases inside the rotor, the moment of inertia changes. Hence the time needed to reach a particular angular velocity is increased, according to the angular acceleration equation (1), as follows:

$$\alpha = \frac{\partial \omega}{\partial t} \qquad (1),$$

wherein $\alpha$ refers to the angular acceleration, $\partial\omega$ refers to a change in angular velocity and $\partial t$ refers to a change in time.

The torque correlates with the angular acceleration, according to rotational analogue of Newton's second law as in the following equation (2):

$$\tau = I\,\alpha \qquad (2),$$

wherein $\tau$ refers to a torque and I refers to a moment of inertia.

In a next stage, a net torque may be determined, which may be the sum of the individual torques. If there was a rotational equilibrium, there would not be a net torque on the object. There may be individual torques, but they would balance each other out of the equation.

In this case the net torque may be calculated as the applied torque $\tau_A$, which may correlate with the rotation frequency of the rotor, minus the frictional torque. The frictional torque may include bearing friction $\tau_{JB}$ (e.g., friction between the bearing and the rotor), thrust bearing $\tau_{TH}$ (e.g., lifting of the rotor due to a change in the diameters at the top and at the bottom bearings), air drag $\tau_{drag}$ on the rotor and rotor losses $\tau_{loss}$. The following equation (3) summarizes the calculation of the net torque as follows:

$$\tau_{net} = \tau_A - (\tau_{JB} + \tau_{TH} + \tau_{drag} + \tau_{loss}) \quad (3)$$

With equation (3), equation (2) may then be rewritten as in equation (4):

$$\tau_{net} = I\,\alpha \qquad (4)$$

According to the afore mentioned equations, a change in the moment of inertia $I$, and therefore a change in the loading of the rotor, has a determinable effect on the angular acceleration of the rotor $\alpha$ and can be determined by differentiating equation (4) or computer implementations and/or finite approximations thereof, e.g., using a difference operator.

The method may therefore rely on the angular acceleration $\alpha$ of the rotor, which may be measured as a change in rotation frequency of the rotor. Such a change in rotation frequency may include modifying the fluid pressure, which may be effected by providing transient control parameters. The transient control parameters are therefore defined as parameters that are configured to be controlled by the operator and wherein a change of the transient control parameters may directly or indirectly produce a pressure change of the fluid that is pumped into the feed passage.

The produced change in rotation frequency of the rotor may subsequently be measured using the rotation sensor. The rotation sensor may transmit the change in rotation frequency to the processor, such as a microprocessor in the form of rotor rotation data. After the microprocessor receives the rotor rotation data that are measured during the change in the rotation frequency, the microprocessor may determine a load of the accumulated particulate contaminant from fluid by a particulate contaminant deposited on an inner surface of the wall of the rotor based on the loading of the rotor. As stated above, the loading may be determined based on the rotor rotation data and the transient control parameters.

According to various embodiments, the transient control parameters may be indicative of a change in operation of a fluid pumping system. In some embodiments, the change in operation of a fluid pumping system may include interrupting or stopping the flow of the fluid to the feed passage. In other embodiments, the change in operation of a fluid pumping system may include starting or accelerating the flow of the fluid to the feed passage. In other embodiments, the change in operation of a fluid pumping system may include reversing. For example, the transient control parameters may involve a start of an engine (e.g., a motor, e.g., an electric motor) or an increase of an engine load of an engine (e.g., a motor, e.g., an electric motor) that produces a fluid pressure through the fluid pumping system. Alternatively, the transient control parameters may involve the stop or the decrease of engine load of an engine that is configured to operate the fluid pressure through the fluid pumping system. Additionally or alternatively, the transient control parameters may involve a change in a temperature of the fluid (e.g., of the cleaned fluid, e.g., of the contaminated fluid), which may produce, or be indicative for, a change in the fluid pressure. Additionally or alternatively, the change in the temperature of the fluid may change the viscosity of the fluid, which may produce, or be indicative for, a change in the fluid pressure.

According to various embodiments, there may be provided a more particular method, wherein reference data are used in a calibration. The method may include some or all of the method steps of the previously described method, and may additionally include a step, in which fluid pressure points at different time stamps are included by or derived from the transient control parameters, and whereby the rotor rotation data include a plurality of data points of different time stamps (e.g., of the same different time stamps as of the fluid pressure points), and the method may further include a step of matching the plurality of data points or information derived therefrom against reference data, obtaining a corresponding loading factor; and using the corresponding loading factor or a value derived therefrom as the loading of the rotor, e.g., setting the loading of the rotor to the corresponding loading factor or a value derived therefrom.

For example, fluid pressure points at different time stamps (e.g., at a time $t_0, t1, t_2, ..., t_n$) may be included in or derived from the transient control parameters and the rotor rotation data may include a plurality of data points at/having different time stamps (e.g., at a time $t_0, t1, t_2, ..., t_n$). The method may then include matching the plurality of data points or information derived therefrom against the reference data. A corresponding loading factor may be determined based on said matching and the corresponding loading factor or a value derived therefrom may be used to determine the loading of the rotor. The calibration method may be carried out based on a temperature measurement or based on the type of fluid. Advantageously, by determining the loading of the centrifugal separator arrangement using a calibration method as described herein, frictional torque that may not be considered in the applied torque would not result in any uncertainty, since the determination of the loading is based on reference data rather than being determined purely mathematically. Hence, the reference data may include reference data points which may be obtained, e.g., by loading a reference centrifugal separator arrangement under controlled conditions, and determining corresponding loading factors from the reference data points.

The rotor rotation data may, in some embodiments, describe a curve. For example, in some embodiments, the plurality of data points may include 10 or more data points at/having different time stamps (e.g., at a time $t_0, t_1, t_2, ..., t_{10}, ..., t_n$) and the reference data may include model reference data points that may be obtained by loading the reference centrifugal separator under controlled conditions, and a corresponding loading factor. The method 300 may then further include extracting coefficients of the plurality of data points included in the rotor rotation data as information derived from the plurality of the data points, which may involve mathematical operations such as fitting a curve, determining a 2nd derivative, and/or fitting a polynomial to an nth degree (n being an integer equal to 2 or larger). The matching may then include selecting model reference data points nearest to the extracted coefficients.

According to various embodiments, there may be provided a further method, wherein fluid pressure data points are measured, each having a different time stamp. Accordingly, the method may include some or all of the method steps of the method as previously described, and may additionally include a step of providing fluid pressure data including two or more fluid pressure points each having a different time stamp, and further providing fluid temperature data points, each having a different time stamp. In other words, the fluid pressure data may include two or more fluid pressure points, wherein each of the two or more fluid pressure points may have a different time stamp (e.g., at a time $t_0$, $t_1$, $t_2$, ..., $t_n$). The fluid pressure points at/having different time stamps may be included in or may be derived from the transient control parameters. Based on the two or more fluid pressure points obtained at the different time stamps, an expected time may be determined at which a pre-determined rotation would be achieved. The rotor loading may then be determined based on a difference of the expected time with a measured time, wherein the measured time at which a pre-determined rotation would be achieved may be obtained from the rotor rotation data. In embodiments where the fluid temperature would vary during the measurement, the method may additionally include measuring fluid temperature data points each having/at a different time stamp (e.g., at a time $t_0$, $t_1$, $t_2$, ..., $t_n$) and determining an expected time necessary for achieving the pre-determined rotation based on the fluid pressure points having/at different time stamps and the fluid temperature points having/at different time stamps.

The pre-determined rotation may include, or consist of, a rotation frequency of an operation mode and an initial state may be a resting state of zero rotation frequency (e.g., at a time $t_0$). Alternatively, the initial state may be an operation mode with an operation rotation frequency different than zero (e.g., at a time $t_n$) and the pre-determined rotation may include, or consist of, a rotation frequency lower than the operation rotation frequency, and may be optionally zero.

The method may further include determining whether a direction of a change in the rotation frequency of the rotor may be indicative of a positive acceleration, which may imply a start of the engine or an increase in the engine load that is configured to operate the fluid pressure through the fluid pumping system. Alternatively, the method may further include the determination whether a direction of a change in the rotation frequency of the rotor may be indicative of a negative acceleration, which may imply a stop of the engine or a decrease of the engine load that is configured to operate the fluid pressure through the fluid pumping system.

The method may include determining an expected rotation frequency that may be expected from a pre-determined time based on the fluid pressure points having/at different time stamps and fluid temperature points having/at different time stamps, wherein the fluid pressure points having/at different time stamps may be included in or may be derived from the transient control parameters, and determining the rotor loading based on a difference of the expected rotation frequency with a measured rotation frequency. The measured rotation frequency may be obtained through rotor rotation data.

According to another aspect, there may be provided a method of determining a loading of a rotor of a centrifugal separator arrangement, the centrifugal separator arrangement being described as herein before. The method may include detecting a transient event causing a modification in an applied fluid pressure. The detection may be provided by the detector, which may optionally be included in the centrifugal separator arrangement. The detector may be configured to detect a change of a transient parameter. The change of the transient parameter may include, for example, a change of a temperature of the fluid and/or a change of a temperature of the fluid. Accordingly, the detector may include, or be, a pressure sensor and/or a temperature sensor. The change of the transient parameter may include a spontaneous (e.g., uncontrolled) change of the transient parameter.

The method may further include detecting a change in a rotation frequency of the rotor being produced by the modification in the fluid pressure applied to the feed passage according to the transient event, for example according to the change in the transient parameter. The method may further include receiving, from the rotation sensor, rotor rotation data corresponding to the change in the rotation frequency of the rotor. The method may further include determining a load of accumulated particulate contaminant separated from the cleaned fluid of the rotor caused by the particulate contaminant deposited on an inner surface of the wall, wherein the loading of the rotor may be determined based on the rotor rotation data and the transient parameters.

According to various embodiments, the detection of the transient event causing the modification in the applied fluid pressure may include detecting an event that may be indicative of a spontaneous change, or a random change, in operation of the fluid pumping system. The transient event may thus include a spontaneous interruption or an end of the flow of the contaminated fluid to the feed passage. In other embodiments, the change in operation of a fluid pumping system may include the flow of the contaminated fluid to the feed passage to be started or accelerated. In other embodiments, the change in operation of a fluid pumping system may include the operation of a fluid pumping system to be reversed. For example, the transient event causing the modification in the applied fluid pressure may involve an engine to be started or an engine load of the engine to be increased that produces a fluid pressure through the fluid pumping system. Alternatively, the transient event causing the modification in the applied fluid pressure may involve an engine load of an engine that is configured to operate the fluid pressure through the fluid pumping system to be ended or decreased. Additionally or alternatively, the transient event causing the modification in the applied fluid pressure may involve a temperature of the contaminated fluid to be changed, which may produce, or be indicative for, a change in the fluid pressure. Additionally or alternatively, the change in the temperature of the contaminated fluid may change the viscosity of the contaminated fluid, which may produce, or be indicative for, a change in the fluid pressure.

According to various embodiments, the method of determining a loading of a rotor of a centrifugal separator arrangement, the centrifugal separator arrangement being described as herein before, may include providing a transient event causing a modification in an applied fluid pressure. According to various embodiments, providing the transient event causing the modification in the applied fluid pressure may include providing an event that may be indicative of a change in operation of the fluid pumping system, which is described herein before.

In another embodiment, there may be provided a fluid cleaning system configured to provide a determination of a loading of a rotor of a centrifugal separator arrangement according to the methods for determining a loading of the as described herein, the system including the centrifugal separator, the rotation sensor, the energy converter, and a processor, such as, a microprocessor. The fluid cleaning system may include some or all of the elements of the centrifugal separator arrangement 100 as described herein before. Hence, the centrifugal separator arrangement may include the rotation sensor 172, which may optionally be an electrical rotation sensor. The centrifugal separator arrangement 100 may further include the detector configured to detect a change of a transient parameter or a transient control parameter.

The microprocessor may be configured to determine a loading of accumulated particulate contaminant from fluid of the rotor caused by particulate contaminant deposited on an inner surface of the wall, wherein the loading may be determined based on the rotor rotation data and the transient control parameters.

According to various embodiments, the fluid cleaning system may further include a determination circuit. The determination circuit may be configured to determine whether the rotor rotation data is indicative of a positive or a negative acceleration. If the determination circuit determines that a negative acceleration is present, the determination circuit may be further configured to determine a time necessary for achieving a threshold low rotation (e.g., a rest state). Alternatively, the determination circuit may be further configured to determine a time necessary for achieving a stable state (e.g., a low slope), based on a determined reference rotation and a determined change in pressure. In some embodiments, the determination circuit may be a separate unit detached from the stationary casing and may be included in the microprocessor.

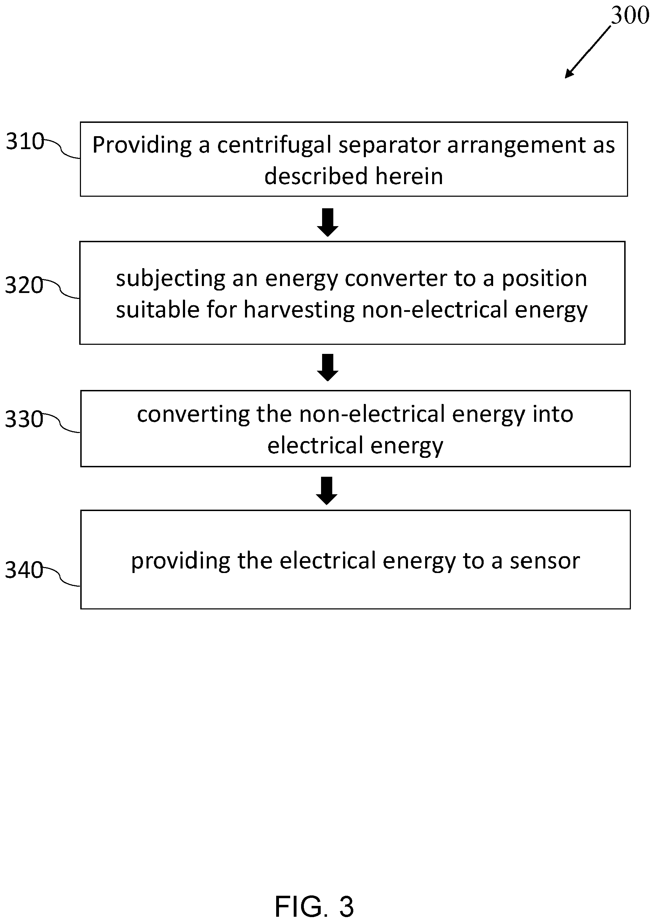

In another aspect, there is provided a method 300 for energy harvesting in the centrifugal separator arrangement. The method 300, as illustrated in FIG. 3, may include a step 310 of providing the centrifugal separator arrangement as described herein before. The method 300 may include a step 320 of subjecting the energy converter to a position suitable for harvesting the non-electrical energy. The method 300 may include a step 330 of converting the non-electrical energy into electrical energy. The method 300 may include a step 340 of providing the electrical energy to the sensor. It is understood that the method 300 may also include a step of operating the centrifugal separator arrangement for cleaning contaminated fluids. During such operation, the non-electrical energy that is generated may be harvested by using the energy converter. The method 300 may also include storing the electrical energy in the energy storage device described for the centrifugal separator arrangement for later use.

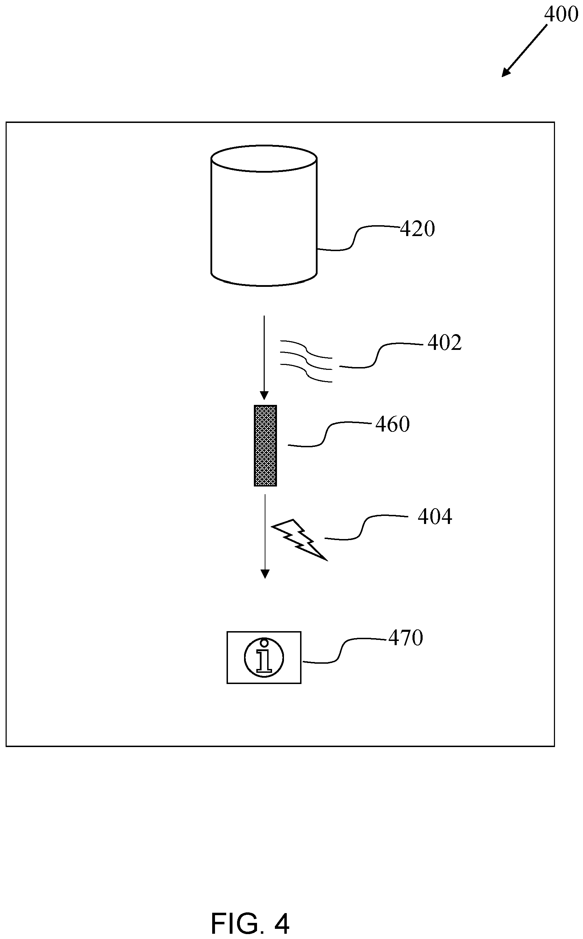

In another aspect, there is provided a system 400 for energy harvesting in the centrifugal separator arrangement. The system 400 may include the centrifugal separator arrangement as described herein before. As shown illustratively in FIG. 4, the system 400 may thus include the rotor 420, which generates non-electrical energy 402. This non-electrical energy 402 may be harvested by the energy converter 460 and converted into electrical energy 404 during operation of the centrifugal separator arrangement.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

In the context of various embodiments, the articles "a", "an" and "the" as used with regard to a feature or element include a reference to one or more of the features or elements.

As used herein, the term "and/or" includes any and all combinations of one or more of the associated listed items.

As used herein, each of the terms "comprising" and "including" may include the meaning of being, being made of, or consisting of. For example, "comprising a centrifugal separator arrangement" or "including a centrifugal separator arrangement" may include the meaning of being, being made of, or consisting of a centrifugal separator arrangement.

**Example 1**

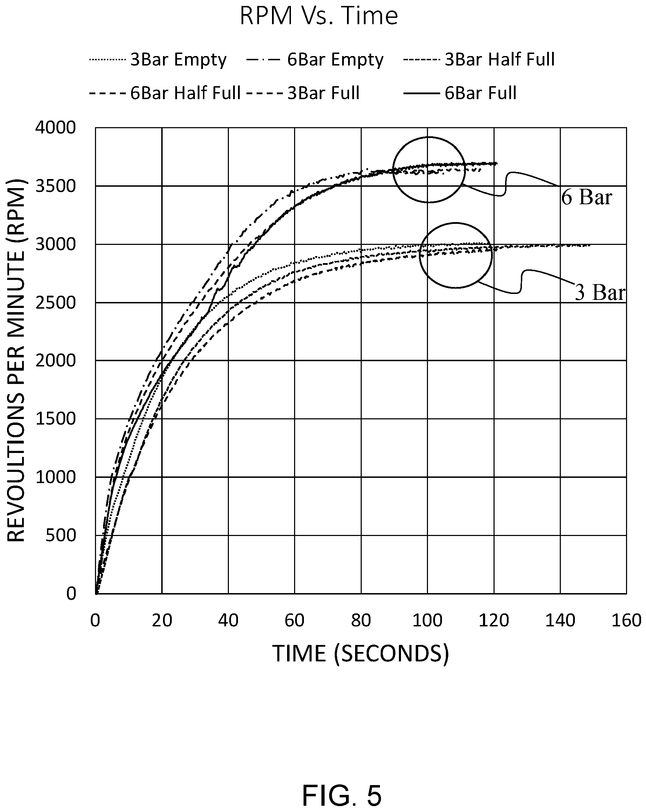

Example 1 illustrates the effectiveness of the method of determining a loading of the rotor of the centrifugal separator arrangement. In particular, it illustrates the time difference in accelerating a rotor at different rotor conditions. In brief, rotor speeds are relative to a fluid (e.g., oil) pressure and to a temperature of the fluid. Hence, the time difference in rotor rotation frequency in dependency of an applied fluid pressure was compared between i) a centrifugal separator arrangement that was full; a centrifugal separator arrangement that was half-full and iii) a centrifugal separator arrangement that was empty. Starting from a resting state, all three centrifugal separator arrangements were subjected to an applied fluid pressure of 3 bar and 6 bar. The results of the experiment were presented in FIG. 5, which is a graph that correlates the rotation frequency (revolutions per minute (rpm)) against time (seconds). The result was a curve comparing the achieved rotation frequency of each of the three arrangements at a given time.

FIG. 5 illustrates a graphical correlation of the rotor rotation frequency versus time. Of the three arrangements described above, the full centrifugal separator arrangements took the longest time for increasing rotation frequency. The half-full centrifugal separator arrangements took a medium amount of time for increasing rotation frequency, while the empty centrifugal separator arrangements were fastest in increasing rotation frequency. It was further shown that all three centrifugal separator arrangements accelerated to a given rotation frequency much faster at an applied pressure of 6 bar, *versus* an applied pressure of 3 bar. The area under each curve may be determined by integrating the equation of the curve and matching the obtained data against a reference table.

**Example 2**

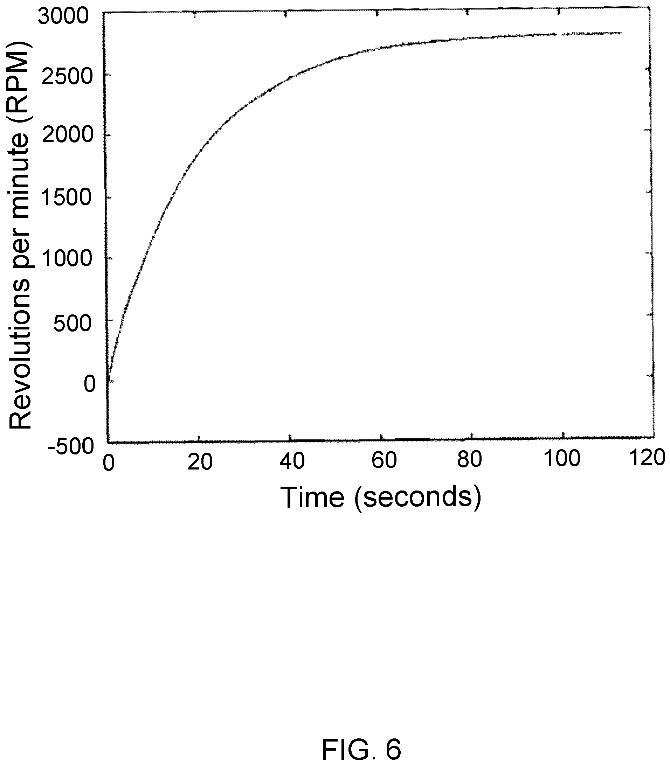

Example 2 illustrates an example of data processing for the method of determining a loading of the rotor of the centrifugal separator arrangement, as shown in FIG. 6. FIG. 6 illustrates a curve fitting as exemplarily used in the present application as type of data processing based on measured points. In FIG. 6, the solid line illustrates a fitting function derived from these measured points. In this respect, the measured points have been subjected to a least-square fitting function applying a polynomial of 15th order resulting in the solid line as shown in FIG. 6.

**Claims**

1. A centrifugal separator arrangement (100), the arrangement (100) comprising:

   - a centrifugal separator comprising:

      a stationary casing (110) defining an enclosure;
      a rotor (120) comprising a wall (122) defining an inner volume, wherein the rotor (120) is rotatably mounted in the enclosure to rotate about a rotation axis;
      a feed passage (130) for supplying a contaminated fluid comprising particulate contaminant and allowing the contaminated fluid to flow to the inner volume of the rotor (120); and
      an egress opening (140) for releasing a cleaned fluid from the centrifugal separator,
      wherein a rotor outlet channel (150) is configured to allow the cleaned fluid to egress in a direction comprising a tangential component with respect to the rotation axis thereby causing an angular displacement of the rotor (120) when the contaminated fluid is applied via the feed passage (130) at a fluid pressure above a fluid pressure threshold, thereby causing the rotor (120) to rotate and to generate non-electrical energy during rotation;

      - an energy converter (160) positioned in proximity to the rotor (120) and configured to collect and convert the non-electrical energy collected from the centrifugal separator into electrical energy;
      - a sensor (170) configured to obtain a parameter associated with the operation of the centrifugal separator, wherein the sensor (170) comprises a processor configured to produce corresponding data; and

   wherein the sensor (170) is operably connected with the energy converter (160) to be powered by the electrical energy produced by the energy converter (160).

2. The centrifugal separator arrangement (100) of claim 1, wherein the non-electrical energy collected from the centrifugal separator is mechanical energy.

3. The centrifugal separator arrangement (100) of claim 2, wherein the mechanical energy is vibrational energy.

4. The centrifugal separator arrangement (100) of claim 3, wherein the energy converter (160) comprises a piezoelectric transducer (180) configured to be subjected to mechanical vibrations.

5. The centrifugal separator arrangement (100) of claim 4, wherein the energy converter (160) comprises an AC-DC rectifier (182) configured to generate DC voltage.

6. The centrifugal separator arrangement (100) of claim 1, wherein the non-electrical energy collected from the centrifugal separator is thermal energy.

7. The centrifugal separator arrangement (100) of claim 6, wherein the energy converter (160) comprises a thermoelectric generator (190) configured to be subjected to a heat source and a heat sink.

8. The centrifugal separator arrangement (100) of claim 6 or claim 7, wherein the energy converter (160) comprises a DC-DC converter (192) configured to adjust DC voltage generated by the energy converter (160).

9. The centrifugal separator arrangement (100) of claim 5 and claim 8, wherein the energy converter (160) comprises a capacitor (162) arranged to smooth out the DC voltage to reduce ripples.

10. The centrifugal separator arrangement (100) of any one of the preceding claims, wherein the energy converter (160) comprises a voltage rectifier (164).

11. The centrifugal separator arrangement (100) of any one of the preceding claims, further comprising an energy storage device (166).

12. The centrifugal separator arrangement (100) of any one of the preceding claims, wherein the sensor (170) is a rotation sensor (172) configured to measure a change in the rotation frequency of the rotor and produce corresponding rotor rotation data.

13. The centrifugal separator arrangement (100) of claim 12, wherein the rotor rotation data and transient control parameters for controlling an applied fluid pressure are configured to be used for determining a load of accumulated particulate contaminant separated from the cleaned fluid caused by the particulate contaminant deposited on an inner surface of the wall (122),
wherein the loading of the rotor (120) is determined based on the rotor rotation data and the transient control parameters.

14. A method (300) for energy harvesting in the centrifugal separator arrangement of any one of the preceding claims, wherein the method comprises the steps of:

- providing the centrifugal separator arrangement of any one of the preceding claims (310),
- subjecting the energy converter to a position suitable for harvesting the non-electrical energy (320);
- converting the non-electrical energy into electrical energy (330); and
- providing the electrical energy to the sensor (340).

15. A system (400) for energy harvesting in the centrifugal separator arrangement of any one of the preceding claims 1 to 13, wherein the system (400) comprises the centrifugal separator arrangement of any one of the preceding claims 1 to 13, and wherein the energy converter is configured to:

harvest non-electrical energy (402) generated during rotation of the rotor (420);
covert the non-electrical energy (402) to electrical energy (404); and
power the sensor (470) with the electrical energy.

FIG. 1

FIG. 2

300

| 310 | Providing a centrifugal separator arrangement as described herein |

⬇

| 320 | subjecting an energy converter to a position suitable for harvesting non-electrical energy |

⬇

| 330 | converting the non-electrical energy into electrical energy |

⬇

| 340 | providing the electrical energy to a sensor |

## FIG. 3

400

420

402

460

404

470

FIG. 4

## RPM Vs. Time

**FIG. 5**

FIG. 6

Europäisches
Patentamt
European
Patent Office
Office européen
des brevets

# EUROPEAN SEARCH REPORT

**Application Number**

EP 24 19 4240

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/029047 A1 (BURFORD NIGEL [GB]) 1 February 2018 (2018-02-01) | 1,2, 10-15 | INV. B04B5/00 |
| A | * paragraphs [0003], [0008], [0022], [0026], [0030]; figures 1-3 * | 3-9 | B04B9/06 B04B9/10 B04B11/02 |
| A | LIU HUICONG ET AL: "Hybrid energy harvesting technology: From materials, structural design, system integration to applications", RENEWABLE AND SUSTAINABLE ENERGY REVIEWS, ELSEVIERS SCIENCE, NEW YORK, NY, US, vol. 137, 24 October 2020 (2020-10-24), XP086422088, ISSN: 1364-0321, DOI: 10.1016/J.RSER.2020.110473 [retrieved on 2020-10-24] * Chapters 2.1, 2.4; figures 1,9,16 * | 3,6 | B04B15/00 |
| A | US 6 011 490 A (TONNESEN HARALD [NO] ET AL) 4 January 2000 (2000-01-04) * claim 1; figure 1 * | 1-15 | TECHNICAL FIELDS SEARCHED (IPC) B04B |
| A | US 2021/146379 A1 (LARSSON PER-GUSTAF [SE]) 20 May 2021 (2021-05-20) * paragraph [0097]; claim 1; figure 6 * | 1-15 | |

The present search report has been drawn up for all claims

| Place of search | Date of completion of the search | Examiner |
|---|---|---|
| Munich | 23 January 2025 | Pössinger, Tobias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 4240

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2025

| Patent document cited in search report | | Publication date | Patent family member(s) | | Publication date |
|---|---|---|---|---|---|
| US 2018029047 | A1 | 01-02-2018 | CN | 107405631 A | 28-11-2017 |
| | | | DE | 112015006428 T5 | 21-12-2017 |
| | | | KR | 20170134391 A | 06-12-2017 |
| | | | US | 2018029047 A1 | 01-02-2018 |
| | | | WO | 2016161578 A1 | 13-10-2016 |
| US 6011490 | A | 04-01-2000 | CA | 2208146 A1 | 27-06-1996 |
| | | | DE | 69516896 T2 | 19-10-2000 |
| | | | EP | 0794837 A1 | 17-09-1997 |
| | | | NO | 301562 B1 | 10-11-1997 |
| | | | US | 6011490 A | 04-01-2000 |
| | | | WO | 9619292 A1 | 27-06-1996 |
| US 2021146379 | A1 | 20-05-2021 | AU | 2018285219 A1 | 02-01-2020 |
| | | | BR | 112019025660 A2 | 25-08-2020 |
| | | | CA | 3067076 A1 | 20-12-2018 |
| | | | CN | 110719816 A | 21-01-2020 |
| | | | CN | 115041308 A | 13-09-2022 |
| | | | EP | 3415239 A1 | 19-12-2018 |
| | | | EP | 3689470 A1 | 05-08-2020 |
| | | | JP | 6940630 B2 | 29-09-2021 |
| | | | JP | 2020523195 A | 06-08-2020 |
| | | | KR | 20200018609 A | 19-02-2020 |
| | | | KR | 20220026604 A | 04-03-2022 |
| | | | NZ | 759549 A | 28-05-2021 |
| | | | RU | 2738326 C1 | 11-12-2020 |
| | | | US | 2021146379 A1 | 20-05-2021 |
| | | | WO | 2018228992 A1 | 20-12-2018 |

EPO FORM P0459

For more details about this annex : see Official Journal of the European Patent Office, No. 12/82